# EUROPEAN PATENT SPECIFICATION

(11) **EP 0 437 224 B1**
(45) Date of publication and mention of the grant of the patent: **06.08.1997**
(21) Application number: 91100141.0
(22) Date of filing: 04.01.1991
(51) Int. Cl.: H03M 1/82, G06F 1/08

(54) **Clock producing apparatus for PWM system digital analog converter use**
Vorrichtung zur Takterzeugung für Digital/Analogwandler in einem Pulsbreitenmodulationssystem
Dispositif de génération de signaux d'horloge pour usage dans un système de conversion numérique-analogique à largeur d'impulsion

(30) Priority: 08.01.1990 JP 1341/90
(43) Date of publication of application: 17.07.1991
(73) Proprietor: MATSUSHITA ELECTRIC INDUSTRIAL CO., LTD., Kadoma-shi, Osaka-fu, 571 (JP)
(72) Inventor: Yamate, Kazunori, Ibaraki-shi, Osaka-fu (JP)
(74) Representative: Eisenführ, Speiser & Partner

(56) References cited:
- EP-A- 0 316 943
- PATENT ABSTRACTS OF JAPAN vol. 10, no. 133 (E-404)(2190) 17 May 1986& JP-A-6263 523 ( MITSUBISHI DENKI KK ) 27 December 1984

## Description

### BACKGROUND OF THE INVENTION

The present invention generally relates to a clock producing apparatus for PWM (pulse width modulation) system D/A converter use for improving the S/N (signal to noise ratio) in a PWM system D/A converter.

Generally, although the apparatuses using the digital art have been put into practical use for a long time, the D/A converter is used in the steps of putting the analog amounts into discrete values so as to effect the digital processing, and converting them again into the analog amounts. Although the resistance rudder type was used as the D/A converting system, the IC adaptation is being effected to reduce the cost. But the conversion accuracy of the D/A converter cannot be provided in terms of accuracy of the resistance values which may be made in the IC interior as the quantisation increases in number, thus resulting in higher cost of the IC for higher accuracy. Recently, the conversion accuracy is retained by the IC adapted D/A converter using the PWM system without dependence upon the resistance value accuracy within the IC.

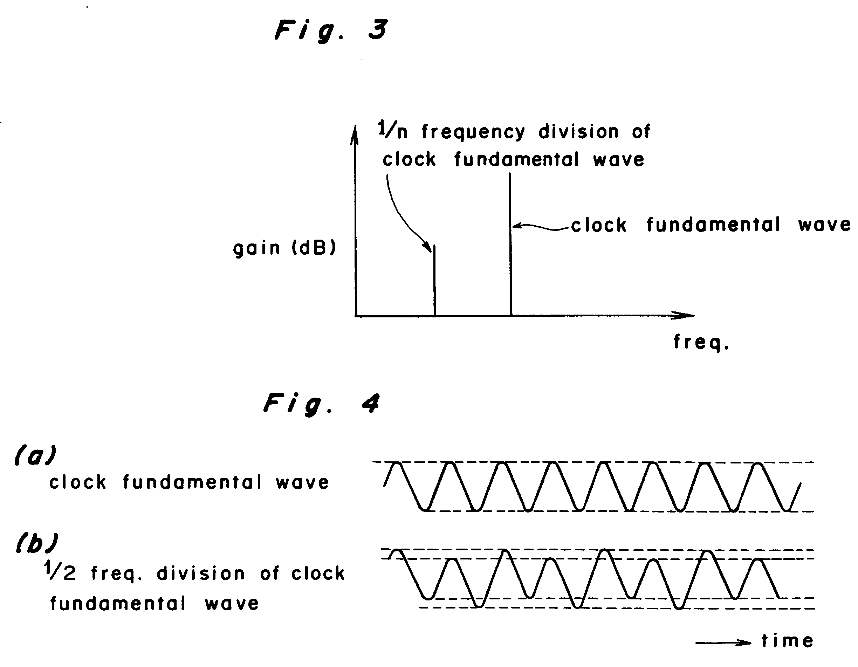

Recently, three types of sampling frequency apparatuses (CD, DAT, BS tuner) are put into the practical use. The clocks of a certain multiple of the input sampling frequency becomes necessary as the clocks of the PWM system. The clock frequency of the PWM system becomes necessary to be switched in accordance with the sampling frequency of the input signals to be D/A converted. As shown in the spectrum chart of Fig. 3, the spectra of the unnecessary components in the frequency division within the switching circuit appear in the clock of the switching circuit output at this time. It is found out that the S/N in the D/A converter of the PWM system may be deteriorated.

The state of the deterioration will be described hereinafter by the following simulation. The explanation will be given with a reference document "Japan Acoustics Society Lecture Theses Collection, October 1988, P411 (1-6-13 Consideration on Clock Jitters in the PWM type D/A Converter) by KANAAKI Tetsuhiko : Matsushita Electric Industrial Co., Ltd., AV Research Laboratory."

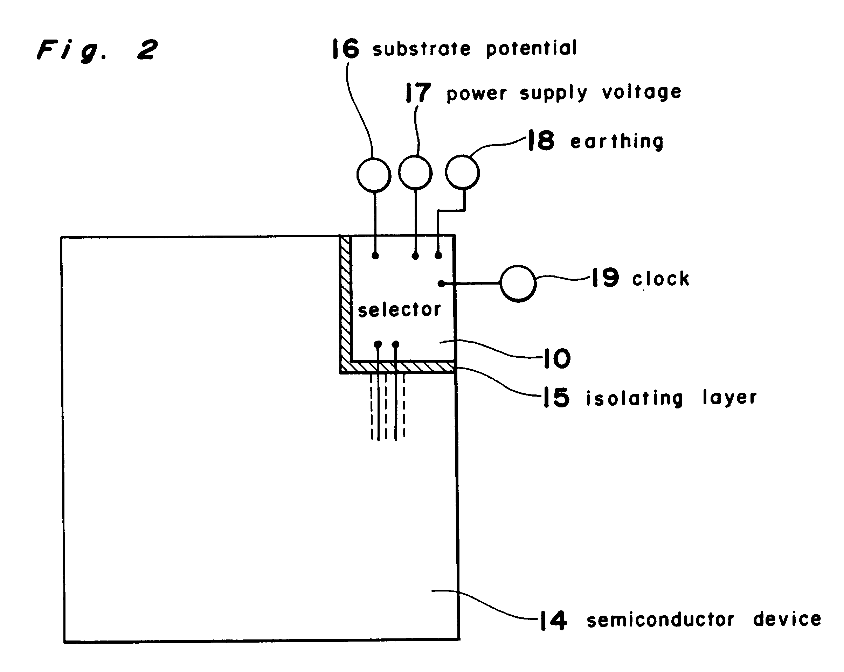

The above described reference literature says, "The clock jitters increase the noise level, and the noise level is proportional to the jitter amount". Namely, as shown in Fig. 3, the 1/n frequency division (n is an integer) of the clock fundamental wave for the PWM system D/A converter use leaks with respect to the clock fundamental wave for the PWM system D/A converter use so as to generate the clock jitters. In Fig. 2, one half frequency division is (n=2).

Fig. 4 shows the wave form chart of a time region. Fig. 4 (a) is a wave form chart of the clock fundamental wave only for PWM system D/A converter use. Fig. 4 (b) is a wave form chart where the one half frequency division output has been mixed with the fundamental waves, showing the frequency region of Fig. 3 converted into the time region.

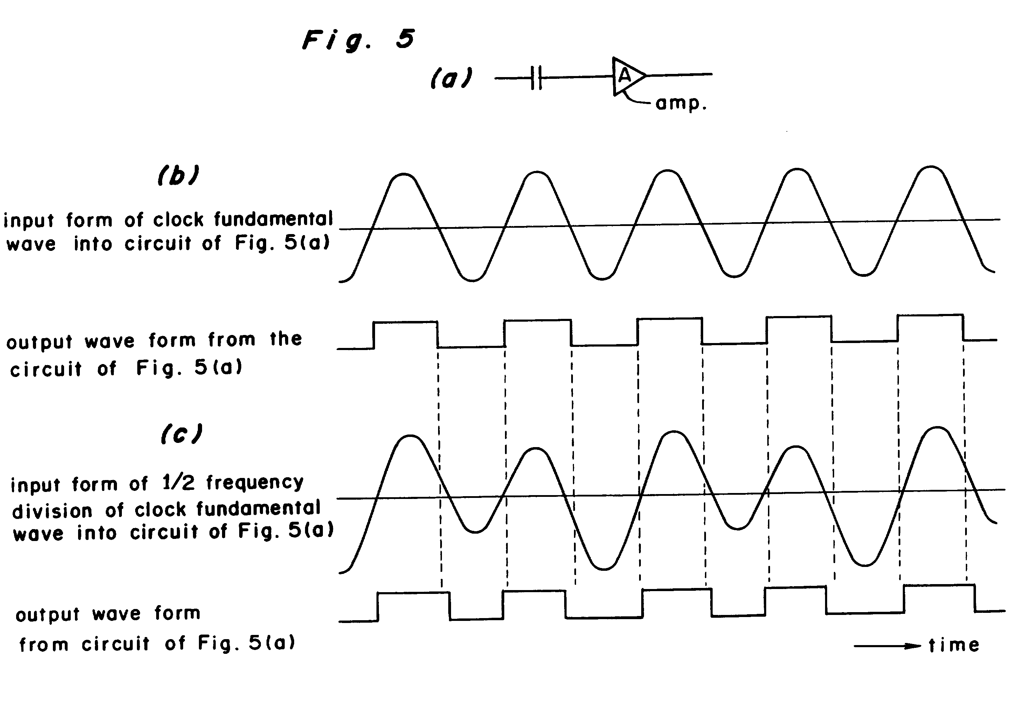

When the output is put through such an amplifier as shown in Fig. 5 (the amplifier A shown in Fig. 5 (a) is an amplifier of a type where the feedback operation has been effected at the input, output operations into the inverter in the logic circuit, with the threshold level existing), such wave forms as in Fig. 5 (b), (c) are provided. Fig. 5 (b) is a wave form chart in the logic circuit when such a fundamental wave shown in Fig. 4 (a) has been inputted into Fig. 5 (a). Fig. 5 (c) is a wave form chart in the logic circuit when the fundamental wave with the one half frequency division output of the Fig. 4 (b) being mixed in it has been inputted into Fig. 5 (a). Therefore, it is found out that the jitters have been caused in Fig. 5 (c). Therefore, the noises by the jitters are increased as shown in the above described reference literature.

Assume that the sampling frequency is fs when the input sampling frequency has been changed, and the clocks of the PWM shaped D/A converter are given in fs X ℓ (the ℓ is an integer, 128, 192, 384, 768 are generally used under the existing state). But if the fs is changed into fs1 and fs2, the clocks of the D/A converter for PWM use are necessary to be changed into the fs1 · ℓ and the fs2 · ℓ. At this time, a selector circuit of the fs1 · ℓ and fs2 · ℓ becomes necessary.

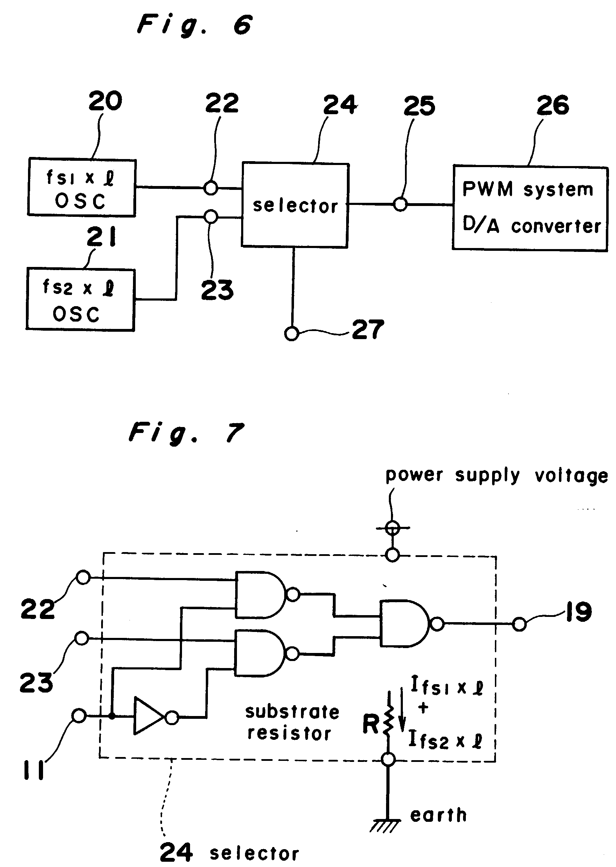

Fig. 6 is a block diagram for explaining it. In Fig. 6, reference numeral 20 is a fs1 X ℓ oscillator, reference numeral 21 is a fs2 X ℓ oscillator. The outputs thereof are inputted into the selector input terminals 22, 23 of the selector circuit 24, and the clock for PWM system D/A converter to be outputted from the selector output terminal 25 use are fed into the PWM system D/A converter 26. Also, the selector circuit 24 is switched by a switching control signal to be inputted from the switching terminal 27 so as to select either of the selector input terminals 22, 23.

Fig. 7 is a block diagram showing the details of the selector circuit 24. In Fig. 7, if the substrate voltage is slightly changed by the currents Ifs1 X ℓ, Ifs2 X ℓ running through the substrate when the fs1 X ℓ oscillator 20, the fs2 X ℓ oscillator 21 have been selected in a case where the impedance of the substrate resistor R is high, the spectrum corresponding to the frequency of the current running through the substrate resistor turns round into the selector circuit 24 and is registrated on the spectrum of the clock. Also, the turning round from the power supply voltage within the IC is also effected.

The unnecessary spectrum is registrated upon the clock spectrum of the PWM system in this manner so as to cause the deterioration of the S/N (signal to noise ratio) in the D/A convertor of the PWM system.

EP-A-0 316 943 defining the closest prior art from which the invention proceeds discloses a semiconductor integrated circuit, in particular a microcomputer, which comprises a clock generating circuit. The operation of the clock generating circuit is once stopped when the oscillation output signals are to be selectively transmitted to the clock generating circuit via a multiplexer. The oscillation output signals are generated by a first oscillation circuit which performs the oscillation operation at a relatively high frequency and by a second oscillation circuit which steadily performs the oscillation operation and a relatively low frequency. Further, the clock generation operation is started in synchronism with the switched oscillation output.

### SUMMARY OF THE INVENTION

The present invention has been developed with a view to substantially eliminating the above discussed drawbacks inherent in the above description, and for its essential object to provide an improved clock oscillating apparatus for PWM system D/A converter use.

Another important object of the present invention is to provide an improved clock oscillating apparatus for PWM system D/A converter use which does not cause the above described unnecessary spectra.

In accomplishing these and other objects, according to the present invention, there is provided a clock producing apparatus for PWM system digital analog converter use comprising an oscillating circuit for effecting oscillations in synchronous relation with input signals received by said oscillating circuit with the oscillation frequency of an integer multiple of the minimum common multiple of the different input sampling frequencies of said input signals, and a frequency deviding circuit having clock inputs for dividing the clock frequency of said oscillating circuit (1) so as to produce output signals of respectively different input sampling frequencies. characterized by a switch means for selecting only the clock inputs of said frequency dividing circuit corresponding to the input sampling frequencies to be selected so as to input the output signal of said oscillation circuit into said selected clock inputs of said frequency dividing circuit and to stop the clock inputs of said frequency dividing circuit corresponding to the input sampling frequencies which are not selected, and a selecting circuit for selecting the output signals of said frequency dividing circuit corresponding to the selection of the input sampling frequencies by said switching means.

A further advantageous embodiment is defined in claim 2.

Further, in the above described construction, the present invention is adapted to isolate the selecting circuit for selecting the frequency dividing outputs by the isolation layer from the other circuits in the semiconductor device, feed the substrate electric potential, the power supply voltage and the earthing from the semiconductor device external portion so as to isolate them from the other circuits, protect the input signals, which goes into the selecting circuit for selecting the above described frequency division outputs, by the earth shielding wires so that the respective input signal wirings may not become adjacent with respect to each other.

In the above described construction, at the front stage where the clock for the PWM system D/A converter use is selected, a switch for feeding the clock inputs to the frequency dividing circuit exists so as to correspond to the input sampling frequencies of two or more by one oscillating circuit. The selecting operation is being effected by the selecting circuit so as to obtain the selected input sampling frequency, and at the same time, the clocks are stopped without being inputted to the frequency dividing circuit corresponding to the input sampling frequency which is not selected so as to prevent the unnecessary spectra from being caused.

Also, even on the semiconductor device, the portion which has the common impedance with the other circuits is removed by the feeding of the substrate, the power supply voltage and the earthing from the external portion of the semiconductor with the selecting circuit being isolated by the isolating layer from the other circuits. As there may have a possibility of coupling by the capacity on the wirings of the semiconductor device because of the higher frequency in the frequency division output, the earthing shielding wires are inserted into the wirings of the above described frequency division outputs so that the wirings for the frequency division output use may not be adjacent so as to prevent the unnecessary spectra from being caused. Therefore, the spectrum purity of the clocks for PWM system D/A converter use may be increased, the unnecessary spectra are removed so as to function of reducing the jitters of the clocks for the PWM system D/A converter use.

### BRIEF DESCRIPTION OF THE SEVERAL VIEWS

These and other objects and features of the present invention will become apparent from the following description taken in conjunction with the preferred embodiments thereof with reference to the accompanying drawings, in which;
Fig. 1 is a block diagram of a clock producing apparatus for PWM system digital analogue converter use in one embodiment of the present invention;
Fig. 2 is a model for realizing the selecting circuit of the clock producing apparatus on the semiconductor device;
Fig. 3 is a spectrum chart of clocks in a case where the clock jitters are caused;
Fig. 4 (a), (b) are a time region wave form chart of the clock fundamental wave only and a time region wave form chart with the divided frequency being mixed in it;
Fig. 5 (a) through (c) are a block diagram of an amplifier in a case where a gate has been constructed and is a wave form chart in a logic circuit when the wave form signals of the Fig. 4 (a) and (b) have been inputted into the amplifiers of Fig. 5 (a);
Fig. 6 is a block diagram in the conventional embodiment in a case where the clock jitters are caused; and
Fig. 7 is a block diagram showing the details of the selection circuit of Fig. 6.

### DETAILED DESCRIPTION OF THE PREFERRED EMBODIMENTS

Before the description of the present invention proceeds, it is to be noted that like parts are designated by like reference numerals throughout the accompanying drawings.

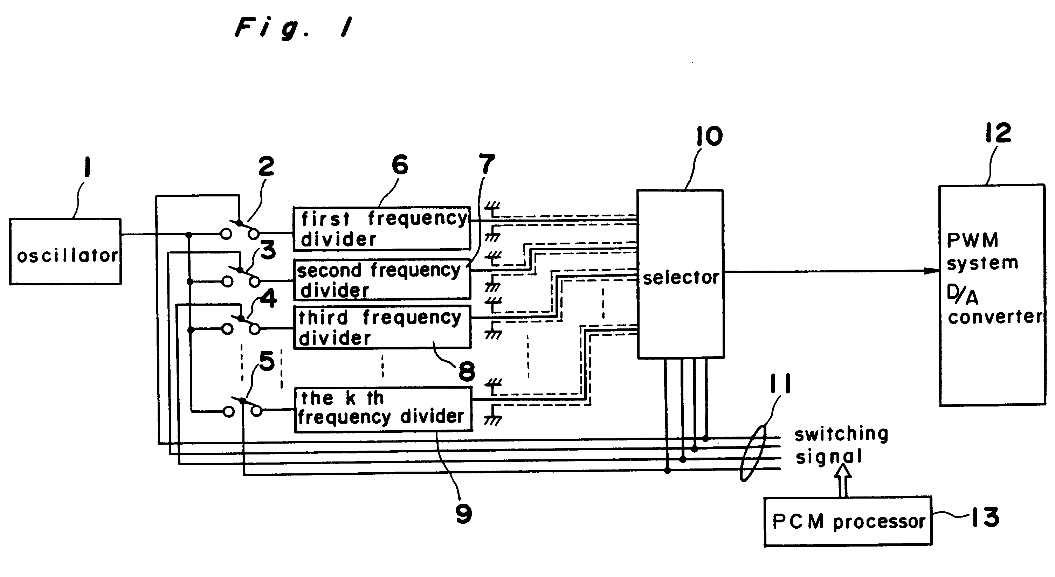

Referring now to the drawings, there is shown in Fig. 1, a block diagram of a clock producing apparatus for PWM system D/A converter use in one embodiment of the present invention, which includes an oscillator 1 that oscillates in synchronous relation with the input signals with the oscillation frequency of the integer multiple of the minimum common multiple of the different input sampling frequency. A first switch, a second switch, a third switch, a K switch are respectively disposed at reference numerals 2, 3, 4, 5 so as to switch the clock inputs of a first frequency divider 6, a second frequency divider 7, a third frequency divider 8, a k frequency divider 9. The outputs of the first through k frequency dividers 6 through 9 are inputted into the selecting circuit 10, are selected with the switching signal 11 obtained by the PCM processing circuit 13 and are inputted into the PWM system D/A converter 12. At this time, the selecting circuit 10 may be an OR gate if the outputs of the first through k frequency dividers 6 through 9 are at the "Low" level.

Also, the frequencies of the first through k frequency dividers 6 through 9 have the relationship of the first frequency divider frequency > the second frequency divider frequency > the third frequency divider frequency > the k frequency divider frequency. Either one of the first through k switches 2 through 5 is closed in accordance with the input sampling frequency, with only one of the first through k frequency dividers 6 through 9 being at operation by the clock inputs. Accordingly, the unnecessary spectra to be caused by the other frequency dividers may be removed.

Fig. 2 is a model where the selecting circuit 10 of Fig. 1 is realized on the semiconductor device. In Fig. 2, a semiconductor device 14 has the PCM processing circuit provided in it, a selecting circuit 10 is isolated from the other PCM processing circuit by the isolating layer 15, a substrate external portion electric potential 16, a power supply voltage 17, an earthing 18 are given from the external portion of the semiconductor device 14, a clock 19 for PWM system D/A converter use is given to the external portion. As shown in Fig. 1, the shielding protection by the earthing is effected at the location where the outputs of the first through the k frequency dividers 6 through 9 are introduced into the selecting circuit 10.

In the above described construction, the portion which has the common impedance with the other circuit is removed by the feeding of the substrate external portion electric potential 16, a power supply voltage 17, an earthing 18 from the external portion so that the turning around of the unnecessary spectra are prevented. Also, the shield protection by the earthing at the location of the introduction into the selecting circuit 10 is useful in the prevention of the crosstalk (on the semiconductor device) with respect to the frequency division output.

As is clear from the foregoing description, according to the arrangement of the present invention, by the prevention of the unnecessary spectrum from being caused even on the circuit and the actual semiconductor device so that the unnecessary spectra may not be caused in the spectra of the input clock into the PWM system D/A converter, the improvements in the S/N of the PWM system D/A converter are effected, the coping operation may be effected with respect to a plurality of input sampling frequencies, thus resulting in the cost down in the IC adaptation, with the practical effect thereof being large.

## Claims

1. A clock producing apparatus for PWM system digital analog converter use comprising an oscillating circuit (1) for effecting oscillations in synchronous relation with input signals received by said oscillating circuit (1) with the oscillation frequency of an integer multiple of the minimum common multiple of the different input sampling frequencies of said input signals, and a frequency dividing circuit (6 to 9) having clock inputs for dividing the clock frequency of said oscillating circuit (1) so as to produce output signals of respectively different input sampling frequencies,
characterized by a switch means (2 to 5) for selecting only the clock inputs of said frequency dividing circuit (6 to 9) corresponding to the input sampling frequencies to be selected so as to input the output signal of said oscillation circuit (1) into said selected clock inputs of said frequency dividing circuit (6 to 9) and to stop the clock inputs of said frequency dividing circuit (6 to 9) corresponding to the input sampling frequencies which are not selected, and a selecting circuit (10) for selecting the output signals of said frequency dividing circuit (6 to 9) corresponding to the selection of the input sampling frequencies by said switching means (2 to 5).

2. An apparatus according to claim 1,
characterized in that said selecting circuit (10) is isolated by an isolation layer (15) from the other circuits on a semiconductor device (14), the substrate electric potential (16), the power supply voltage (17) and the earthing (18) are input from an external portion of said semiconductor device (14) to isolate from the other circuits, and the input signals into said selecting circuit (10) are protected by an earthing shielding wire, so that the respective input signals may not be leaked with respect to each other.

## Patentansprüche

1. Vorrichtung zur Takterzeugung für Digital-Analog-Wandler in einem Pulsbreitenmodulationssystem mit einer Oszillatorschaltung (1) zur Erzeugung von Schwingungen synchron mit von der Oszillatorschaltung (1) empfangenen Eingangssignalen bei einer Schwingungsfrequenz, die ein ganzzahliges Vielfaches des kleinsten gemeinsamen Vielfaches der unterschiedlichen Eingangsabtastfrequenzen der Eingangssignale beträgt, und einer Frequenzteilerschaltung (6-9) mit Taktsignaleingängen zur Teilung der Taktfrequenz der Oszillatorschaltung (1), um Ausgangssignale von entsprechenden unterschiedlichen Eingangsabtastfrequenzen zu erzeugen,
gekennzeichnet durch eine Schaltereinrichtung (2-5) zur Auswahl von nur denjenigen Taktsignaleingängen der Frequenzteilerschaltung (6-9), die den auszuwählenden Eingangsabtastfrequenzen entsprechen, um das Ausgangssignal der Oszillatorschaltung (1) in die ausgewählten Taktsignaleingänge der Frequenzteilerschaltung (6-9) einzugeben und diejenigen Taktsignaleingänge der Frequenzteilerschaltung (6-9) zu blockieren, die denjenigen Eingangsabtastfrequenzen entsprechen, die nicht ausgewählt werden, und eine Selektionsschaltung (10) zur Auswahl der Ausgangssignale der Frequenzteilerschaltung (6-9) entsprechend der Auswahl der Eingangsabtastfrequenzen durch die Schaltereinrichtung (2-5).

2. Vorrichtung nach Anspruch 1,
dadurch gekennzeichnet, daß die Selektionsschaltung (10) durch eine Isolationsschicht (15) von den anderen Schaltungselementen auf einer Halbleiteranordnung isoliert ist, das elektrische Substrat-Potential (16), die Versorgungsspannung (17) und die Erdung (18) von einem externen Abschnitt der Halbleiteranordnung (14) zur Isolierung von den anderen Schaltungselementen eingegeben werden und die Eingangssignale für die Selektionsschaltung (10) durch eine Erdungsabschirmleitung geschützt werden, so daß die entsprechenden Eingangssignale nicht zueinander übersprechen können.

## Revendications

1. Appareil de génération d'horloge pour emploi dans un convertisseur numérique-analogique d'un système PWM comprenant un circuit oscillant (1) pour effectuer des oscillations en relation synchrone avec les signaux d'entrée reçus par ledit circuit oscillant (1), la fréquence d'oscillation étant un multiple entier du plus petit commun multiple des différentes fréquences d'échantillonnage d'entrée desdits signaux d'entrée, et un circuit de division de fréquence (6 à 9) ayant des entrées d'horloge pour diviser la fréquence d'horloge dudit circuit oscillant (1) afin de produire des signaux de sortie ayant des fréquences d'échantillonnage d'entrée respectivement différentes,
caractérisé par un moyen de commutateur (2 à 5) pour sélectionner seulement les entrées d'horloge dudit circuit de division de fréquence (6 à 9) correspondant aux fréquences d'échantillonnage d'entrée devant être sélectionnées de façon à entrer le signal de sortie dudit circuit oscillant (1) dans lesdites entrées d'horloge sélectionnées dudit circuit de division de fréquence (6 à 9) et à arrêter les entrées d'horloge dudit circuit de division de fréquence (6 à 9) correspondant aux fréquences d'échantillonnage d'entrée qui ne sont pas sélectionnées, et un circuit de sélection (10) pour sélectionner les signaux de sortie dudit circuit de division de fréquence (6 à 9) correspondant à la sélection des fréquences d'échantillonnage d'entrée par ledit moyen de commutateur (2 à 5).

2. Appareil selon la revendication 1,
caractérisé en ce que ledit circuit de sélection (10) est isolé par une couche d'isolation (15) des autres circuits sur un dispositif à semi-conducteur (14), le potentiel électrique du substrat (16), la tension d'alimentation (17) et la mise à la terre (18) sont entrés à partir d'une portion externe dudit dispositif à semi-conducteur (14) pour les isoler des autres circuits, et les signaux d'entrée dans ledit circuit de sélection (10) sont protégés par un fil de protection de mise à la terre, de sorte que les signaux d'entrée respectifs ne peuvent pas fuir les uns par rapport aux autres.
